# EUROPÄISCHE PATENTSCHRIFT

(11) **EP 3 726 945 B1**
(45) Veröffentlichungstag und Bekanntmachung des Hinweises auf die Patenterteilung: **20.09.2023**
(21) Anmeldenummer: 20168208.5
(22) Anmeldetag: 06.04.2020
(51) Int. Cl.: H05K 5/00

(54) **TRAG- UND ANDOCKEINRICHTUNG FÜR ELEKTRONIK-GEHÄUSEMODULE**
SUPPORT AND DOCKING DEVICE FOR ELECTRONIC HOUSING MODULE
DISPOSITIF DE SUPPORT ET D'ACCUEIL POUR MODULES DE BOITIER ÉLECTRONIQUE

(30) Priorität: 18.04.2019 DE 202019102256 U
(43) Veröffentlichungstag der Anmeldung: 21.10.2020
(73) Patentinhaber: Dürkopp Adler AG, 33719 Bielefeld (DE)
(72) Erfinder: Harbaum, Maurice, 33611 Bielefeld (DE); Lieberum, Felix, 32051 Herford (DE); Rösler, Uwe, 15370 Petershagen b. Berlin (DE); Pfeiffer, Sven, 33613 Bielefeld (DE); Wigger, Tobias, 57250 Netphen (DE)
(74) Vertreter: Rau, Schneck & Hübner Patentanwälte Rechtsanwälte PartGmbB

(56) Entgegenhaltungen:
- WO-A1-2015/094248
- JP-A- H 053 978
- US-A1- 2016 309 605

## Beschreibung

Die Erfindung betrifft eine Trag- und Andockeinrichtung für Elektronik-Gehäusemodule. Ferner betrifft die Erfindung eine Elektronik-Baugruppe mit mindestens einer derartigen Trag- und Andockeinrichtung sowie eine Nähmaschine mit einer derartigen Elektronik-Baugruppe.

Halterungen für Elektronik-Gehäusemodule, insbesondere für Maschinen-Steuerungsmodule, beispielsweise von Nähmaschinen, sind vom Markt her bekannt. Derartige Trageinrichtungen werden regelmäßig individuell gestaltet. Die WO 2015/094248 A1 offenbart ein Rack zur Aufnahme von Modulen, die bei der Patientenüberwachung zum Einsatz kommen. Die JP H05 3978 offenbart ein Verfahren zur Steuerung externer Ausrüstung für eine elektronische Nähmaschine. Die US 2016/309605 A1 offenbart eine flexibel mit Modulen konfigurierbare elektronische Einrichtung.

Es ist eine Aufgabe der vorliegenden Erfindung, eine Trageinrichtung für ein Elektronik-Modul derart weiterzubilden, dass eine flexible Bestückung mit Elektronikmodulen möglich ist.

Diese Aufgabe ist erfindungsgemäß gelöst durch eine Trag- und Andockeinrichtung mit den im Anspruch 1 angegebenen Merkmalen.

Erfindungsgemäß wurde erkannt, dass eine Trag- und Andockeinrichtung mit mindestens einem Modul-Aufnahmeplatz zur hängenden Aufnahme von Elektronik-Gehäusemodulen zu einer großen Flexibilität führt, was die Möglichkeiten der Bestückung der Trag- und Andockeinrichtung mit entsprechenden Elektronik-Gehäusemodulen angeht. Sowohl die Anzahl der bestückbaren Elektronik-Gehäusemodule als auch, aufgrund deren hängender Aufnahme, die Bauform der Elektronik-Gehäusemodule kann flexibel gestaltet werden. Aufgrund der hängenden Aufnahme können die Elektronik-Gehäusemodule insbesondere verschieden hoch ausgeführt sein, da ein Abstand eines Bodens des jeweiligen Elektronik-Gehäusemoduls zur hängenden Aufnahme nicht festgelegt ist. Die Modul-Tragschieneneinheit sorgt für eine sichere Halterung des Elektronik-Gehäusemoduls im jeweiligen Modul-Aufnahmeplatz. Über eine derartige Trag- und Andockeinrichtung lässt sich eine praktisch beliebig erweiterbare Elektronik-Baugruppe, beispielsweise für Nähmaschinen, realisieren.

Die Trag- und Andockeinrichtung kann als Backplane gestaltet sein.

Eine existierende Konfiguration einer Elektronik-Baugruppe mit einer derartigen Trag- und Andockeinrichtung ist insbesondere um weitere Funktionen erweiterbar. Bei den Elektronik-Gehäusemodulen kann es sich um solche handeln, die eine Motorsteuerung beinhalten und/oder die eine Maschinenkommunikation steuern. Für das Elektronik-Gehäusemodul ist ein Modul aus denjenigen Modultypen denkbar, die in der SPS (Speicherprogrammierbare Steuerung)-Technik eingesetzt werden. Auch ein Netzteilmodul, ein Schrittmotorendstufenmodul oder auch ein I/O-Modul kann als Elektronik-Gehäusemodul zum Einsatz kommen. Generell können diejenigen Modultypen zum Einsatz kommen, die für den allgemeinen Maschinenbau bekannt sind. Insbesondere ein Steuerungserweiterungssystem für Maschinen, beispielsweise für Nähmaschinen, kann hierüber realisiert werden.

Die Trag- und Andockeinrichtung kann genau einen Modul-Aufnahmeplatz aufweisen oder kann mindestens zwei Modul-Aufnahmeplätze aufweisen, und kann zum Beispiel drei, vier, acht oder auch zehn oder noch mehr Modul-Aufnahmeplätze aufweisen. Die Trag- und Andockeinrichtung kann genau einen Multipol-Steckverbinder oder eine Mehrzahl von Multipol-Steckverbindern aufweisen. Die Trag-und Andockeinrichtung kann genau einen Sammel-Multipol-Steckverbinder oder kann mehrere Sammel-Multipol-Steckverbinder aufweisen.

Die Trag- und Andockeinrichtung kann so konfiguriert sein, dass die aufzunehmenden Elektronik-Gehäusemodule nicht kodiert werden müssen und daher frei in einen beliebigen Modul-Aufnahmeplatz der Trag- und Andockeinrichtung gesteckt werden können.

Die Bestückung der Trag- und Andockeinrichtung kann von einer Bedienperson durchgeführt werden, die keine spezifische Elektronikausbildung braucht. Die Trag- und Andockeinrichtung kann so gestaltet sein, dass beim Stecken beziehungsweise beim Entnehmen jeweils eines Elektronik-Gehäusemoduls keine Kabelverbindung zu einer Hauptsteuerung gesteckt beziehungsweise getrennt werden muss.

Eine Modul-Tragschieneneinheit der Trag- und Andockeinrichtung kann von einer weiteren Andockkomponente der Trag- und Andockeinrichtung, die wiederum den Multipol-Verbinder und den mindestens einen Sammel-Multipol-Steckverbinder aufweist, getrennt ausgeführt sein. Die Andocckomponente kann über Rastaufnahmen am Elektronik-Gehäusemodul fixierbar sein. Die Andockkomponente kann eine optionale Verbindungskomponente zur elektrischen Verbindung mit einem externen Tragrahmen aufweisen.

Die Trag- und Andockeinrichtung hat eine Rahmenkomponente, über die die Trag- und Andockeinrichtung an einem externen Rahmenträger zur Halterung der Trag- und Andockeinrichtung montiert werden kann, wobei die Modul-Tragschieneneinheit als zur Rahmenkomponente separate Einheit ausgeführt ist. Eine derartige Unterteilung der Trag- und Andockeinrichtung in eine Rahmenkomponente einerseits und eine hiervon separate Modul-Tragschieneneinheit andererseits ermöglicht es beispielsweise, sowohl die Rahmenkomponente einerseits als auch die Modul-Tragschieneneinheit andererseits als Extrusionskomponente herzustellen. Bei dem externen Rahmenträger kann es sich um eine Tischplatte, um ein Maschinengestell oder um einen Maschinenrahmen handeln. Die Rahmenkomponente kann insbesondere zur Halterung aller Komponenten der Trag- und Andockeinrichtung gestaltet sein.

Die Rahmenkomponente der Trag- und Andockeinrichtung ist mit den Modul-Tragschienen der Modul-Tragschieneneinheit über Rahmenschienen der Rahmenkomponente verbunden, in die komplementäre Verbindungsschienen der Modul-Tragschieneneinheit eingreifen. Eine derartige Rahmenschienen-Gestaltung sorgt für eine sichere Verbindung der Rahmenkomponente mit der Modul-Tragschieneneinheit.

Eine entsprechende Verbindungsschienen-Konfiguration kann auch bei einer Verbindungskomponente vorliegen, die nicht die gesamte Trag- und Andockeinrichtung, sondern beispielsweise eine von einem Moduladapter separate Modul-Tragschieneneinheit haltert.

Die Rahmenschienen der Rahmenkomponente verlaufen senkrecht zu den Modul-Tragschienen der Modul-Tragschieneneinheit. Ein derart zueinander senkrechter Schienenverlauf vermeidet, dass sich beim Bestücken beziehungsweise Entnehmen eines Elektronik-Gehäusemoduls die Modul-Tragschieneneinheit unerwünscht von der Rahmenkomponente löst.

Bei einer Ausgestaltung des Sammel-Multipol-Steckverbinders nach Anspruch 2 ist eine kaskadierte Anordnung möglich, bei der mehrere Trag-und Andockeinrichtungen über ihren jeweiligen Sammel-Multipol-Steckverbinder miteinander verbunden sind.

Eine Kunststoffausführung nach Anspruch 3 führt zu einer leichten und gleichzeitig isolierenden Trag- und Andockeinrichtung.

Eine Rastaufnahme nach Anspruch 4 führt zu einer definierten und sicheren Halterung des Elektronik-Gehäusemoduls im jeweiligen Modul-Aufnahmeplatz. Die Rastaufnahme kann einen Betätigungsgriff aufweisen.

Eine Schutzabdeckung nach Anspruch 5 vermeidet zum Beispiel eine unerwünschte Verschmutzung nicht genutzter Steckverbinder. Über die Schutzabdeckung kann ein Schutz vor mechanischer Einwirkung beziehungsweise ein Schutz vor Fehlbedienung beziehungsweise ein Kurzschluss-Schutz erreicht werden. Die Schutzabdeckung kann individuell für den jeweiligen Steckverbinder gestaltet werden. Für den Sammel-Multipol-Steckverbinder kann eine andere Schutzabdeckung zum Einsatz kommen als für die anderen Multipol-Steckverbinder.

Die Vorteile einer Elektronik-Baugruppe nach Anspruch 6 und einer Nähmaschine nach Anspruch 7 entsprechen denen, die vorstehend unter Bezugnahme der Trag- und Andockeinrichtung bereits erläutert wurden. Über die Trag- und Andockeinrichtung können insbesondere Steuerungsmodule für die Nähmaschine bestückt werden, die Antriebs- beziehungsweise Kommunikationsfunktionen übernehmen.

Ausführungsbeispiele der Erfindung werden nachfolgend anhand der Zeichnung näher erläutert. In dieser zeigen:
- Fig. 1: perspektivisch eine Trag- und Andockeinrichtung mit zwei Modul-Aufnahmeplätzen für Elektronik-Gehäusemodule als Teil einer Elektronik-Baugruppe zum Anbau an eine Maschine, beispielsweise an eine Nähmaschine;
- Fig. 2: die Trag- und Andockeinrichtung aus anderer Perspektive;
- Fig. 3: eine Elektronik-Baugruppe mit der Trag- und Andockeinrichtung und einem Elektronik-Gehäusemodul, in dem Maschinen-Steuerungskomponenten untergebracht sind, gesehen aus einer zur Figur 1 ähnlichen Blickrichtung;
- Fig. 4: die Elektronik-Baugruppe nach Figur 3, gesehen aus einer Blickrichtung ähnlich zur Figur 2, wobei ein Multipol-Steckverbinder der Trag- und Andockeinrichtung, der zu einem nicht genutzten Modul-Aufnahmeplatz gehört, mit einer Schutzabdeckung versehen ist;
- Fig. 5: die Elektronik-Baugruppe, gesehen aus Blickrichtung V in Figur 4;
- Fig. 6: die Elektronik-Baugruppe nach Figur 3, ergänzt um ein weiteres Elektronik-Gehäusemodul, sodass nun beide Modul-Aufnahmeplätze der Trag- und Andockeinrichtung mit jeweils einem Elektronik-Gehäusemodul bestückt sind,
- Fig. 7: in einer perspektivischen Ansicht aus einer zu den Figuren 3 und 6 ähnlichen Richtung zwei über einen Sammel-Multipol-Steckverbinder miteinander verbundene, kaskadierte Elektronik-Baugruppen nach Art von derjenigen der Figur 6, also mit jeweils zwei Modul-Aufnahmeplätzen, die mit je einem Elektronik-Gehäusemodul bestückt sind;
- Fig 8: auf einer zu Fig. 1 ähnlichen Perspektive eine weitere Ausführung einer Trag- und Andockeinrichtung mit genau einem Modul-Aufnahmeplatz; und
- Fig. 9: in einer zu Fig. 3 ähnlichen Darstellung eine Elektronik-Baugruppe mit der Trag- und Andockeinrichtung nach Fig. 8 und einer weiteren Ausführung eines Elektronik-Gehäusemoduls.

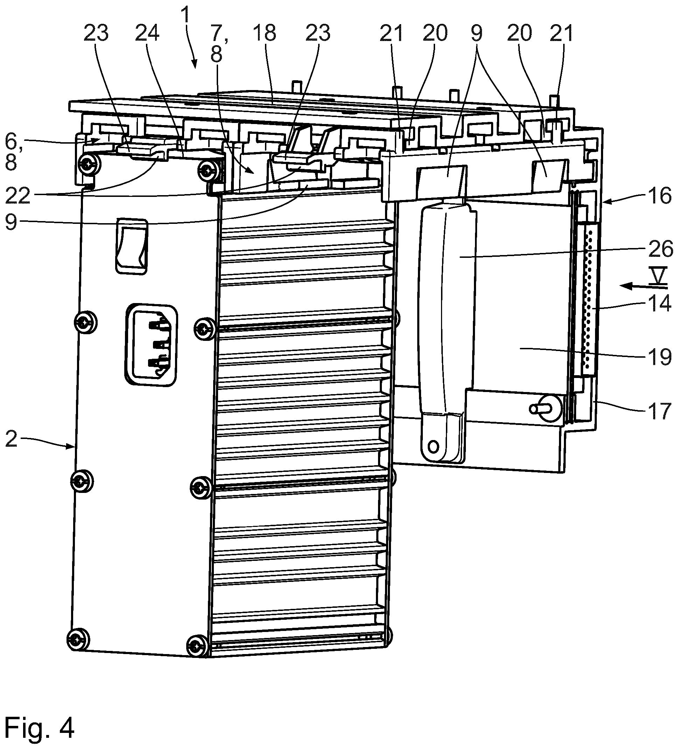

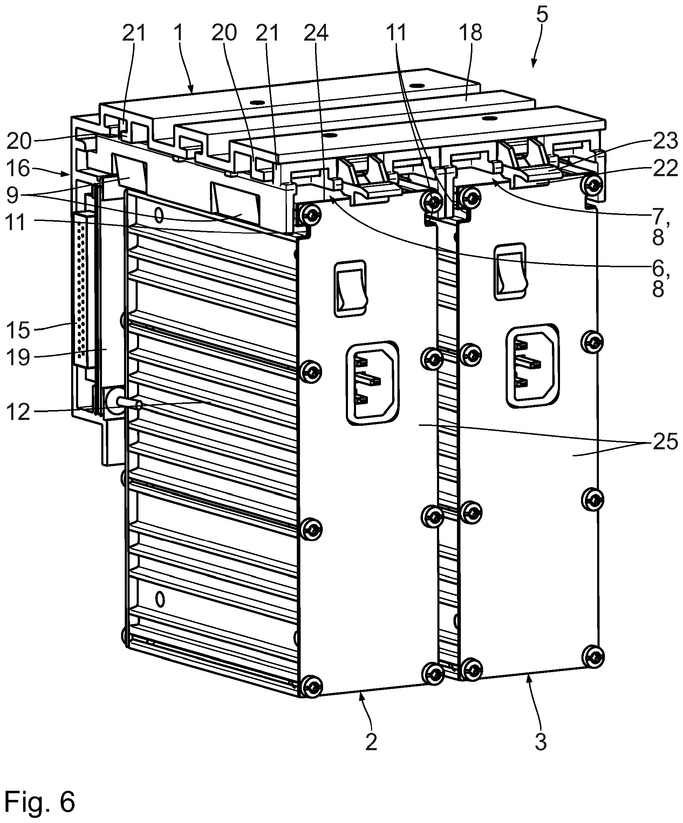

Eine Trag- und Andockeinrichtung 1 dient zur tragenden Aufnahme von Elektronik-Gehäusemodulen 2, 3 (vgl. zum Beispiel Figur 6), sodass insgesamt eine Elektronik-Baugruppe 4 mit teilweise bestückter Trag- und Andockeinrichtung 1 (vgl. Figur 4) oder eine Elektronik-Baugruppe 5 mit vollständig bestückter Trag- und Andockeinrichtung 1 (vgl. Figur 6) resultiert.

In den Elektronik-Gehäusemodulen 2, 3 können Steuerungskomponenten einer Maschinensteuerung, beispielsweise einer Steuerung für eine Nähmaschine, untergebracht sein.

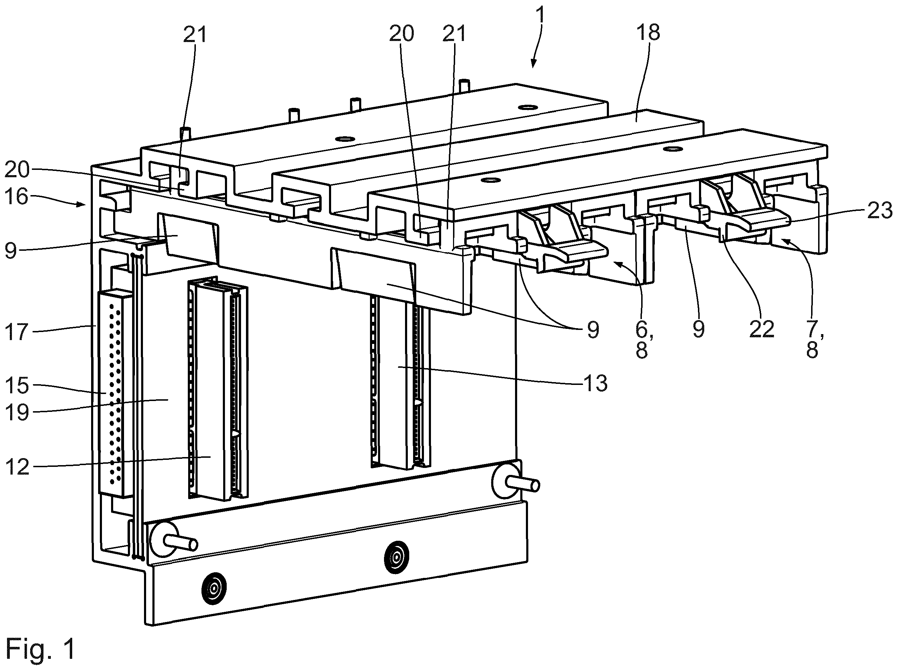

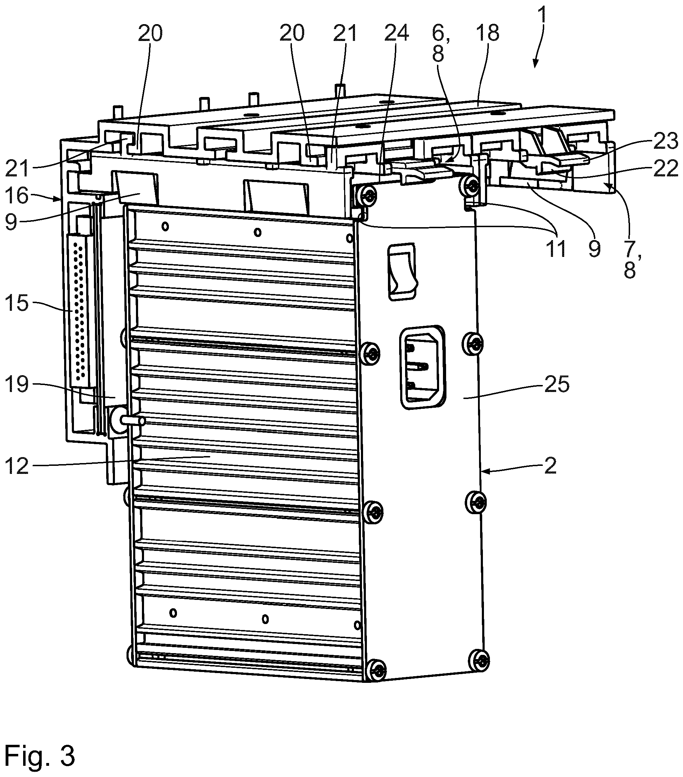

Die Trag- und Andockeinrichtung 1 hat genau zwei Modul-Aufnahmeplätze 6, 7 für genau zwei Elektronik-Gehäusemodule 2, 3. Figur 1 zeigt die Trag- und Andockeinrichtung 1 unbestückt, Figur 3 zeigt die Trag- und Andockeinrichtung bestückt mit genau einem Elektronik-Gehäusemodul 2 und Figur 6 zeigt die Trag- und Andockeinrichtung 1 voll bestückt mit zwei Elektronik-Gehäusemodulen 2, 3.

Die Modul-Aufnahmeplätze 6, 7 sind derart gleich dimensioniert, dass das jeweilige Elektronik-Gehäusemodul 2, 3 wahlweise in einen beliebigen der Modul-Aufnahmeplätze 6, 7 eingesetzt werden kann.

Alternativ zur dargestellten Ausführung der Trag- und Andockeinrichtung 1 mit genau zwei Modul-Aufnahmeplätzen können andere Ausführungen der Trag- und Andockeinrichtung auch mehr als zwei Modul-Aufnahmeplätze, beispielsweise drei, vier, fünf, zehn oder noch mehr Modul-Aufnahmeplätze aufweisen.

Die Modul-Aufnahmeplätze 6, 7 dienen zur hängenden Aufnahme der Elektronik-Gehäusemodule 2, 3. Jeder Modul-Aufnahmeplatz 6, 7 hat eine Hängeaufnahme mit einer Modul-Tragschieneneinheit 8 mit Modul-Tragschienen 9. Die Modul-Tragschieneneinheit ist als Spritzguss-Kunststoffteil gestaltet. Die Modul-Tragschienen 9 sind in mehrere in Längsrichtung beabstandete Schienenabschnitte unterteilt. Die Modul-Tragschienen 9 sind so ausgeführt, dass sie mit komplementär im beziehungsweise am jeweiligen Elektronik-Gehäusemodul 2, 3 ausgeführten Schienenaufnahmen 11 (vgl. zum Beispiel Figur 3) zur tragenden Halterung der Elektronik-Gehäusemodule 2, 3 zusammenwirken können.

Weiterhin hat jeder der Modul-Aufnahmeplätze 6, 7 einen Multipol-Steckverbinder 12, 13 zur elektrischen Verbindung mit dem jeweils aufnehmbaren Elektronik-Gehäusemodul 2, 3.

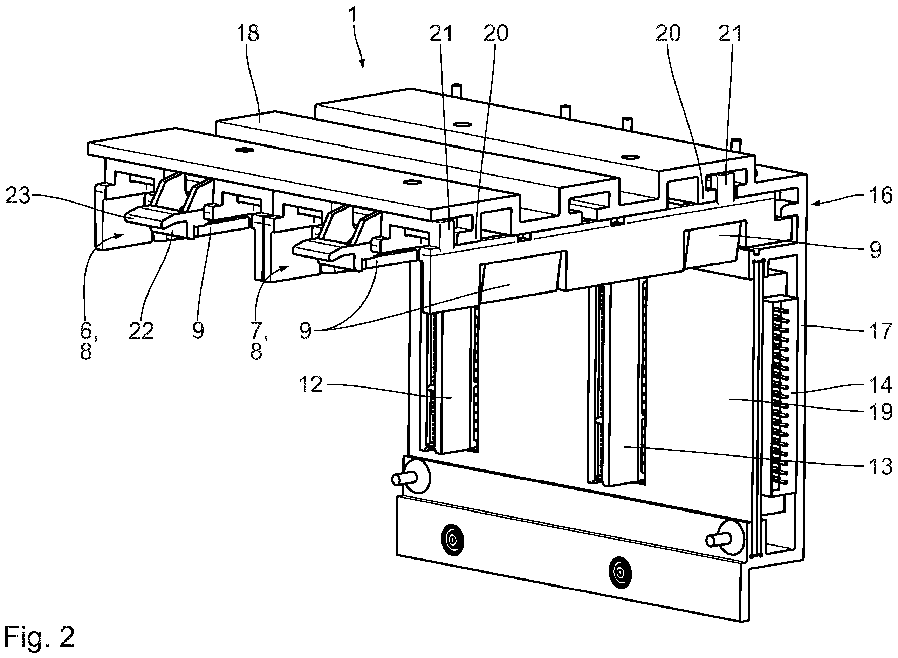

Die Trag- und Andockeinrichtung 1 hat weiterhin zwei Sammel-Multipol-Steckverbinder 14 (vgl. Figur 2) und 15 (vgl. Figur 1) zur elektrischen Verbindung der Modul-Aufnahmeplätze 6, 7 mit einer externen Komponente, also insbesondere der zu steuernden Maschine. Die verschiedenen Pole der Sammel-Multipol-Steckverbinder sind untereinander und mit den Multipol-Steckverbindern 12, 13 jeweils polweise 1: 1 verbunden. Alternativ ist es auch möglich, den jeweiligen Sammel-Multipol-Steckverbinder 14 mit dem Multipol-Steckverbindern 12, 13 in anderer Weise als polweise 1:1 zu verbinden.

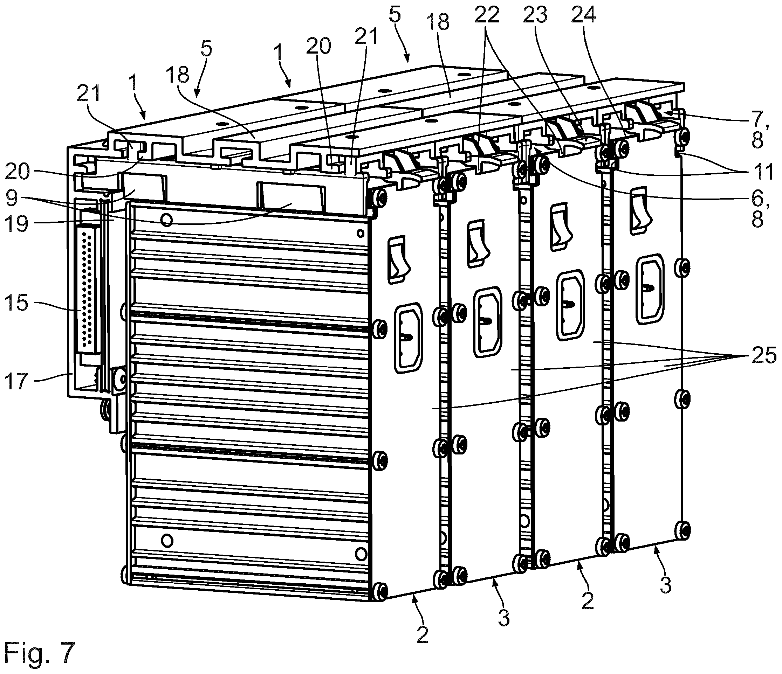

Die Sammel-Multipol-Steckverbinder 14, 15 sind als Steckereinheit 14 und hierzu komplementäre Buchseneinheit 15 ausgeführt. Diese Ausgestaltung macht es möglich, mehrere der Trag- und Andockeinrichtungen 1 miteinander elektrisch zu verbinden, wobei die Steckereinheit der einen Trag-und Andockeinrichtung 1 in die Buchseneinheit 15 der anderen Trag- und Andockeinrichtung 1 eingesteckt ist. Eine derartige kaskadierte Konfiguration zweier Trag- und Andockeinrichtungen 1 zeigt die Figur 7.

Bei einer alternativen Ausführung der Trag- und Andockeinrichtung 1 ist am Ort der Steckereinheit 14 eine Buchseneinheit und am Ort der Buchseneinheit 15 eine hierzu komplementäre Steckereinheit ausgeführt.

Über die jeweils noch freien Einheiten der Sammel-Multipol-Steckverbinder können auch noch weitere Trag- und Andockeinrichtungen 1 elektrisch verbunden werden, sodass flexibel auf die benötigte Anzahl von Elektronik-Gehäusemodulen 2, 3 reagiert werden kann.

Die Trag- und Andockeinrichtung hat eine Rahmenkomponente 16, über die die Trag- und Andockeinrichtung 1 an einem externen Rahmenträger, beispielsweise einem Maschinen-Rahmenträger, zur Halterung der Trag-und Andockeinrichtung 1 montiert werden kann. Die Rahmenkomponente 16 ist als Aluminium-Strangpressprofil gestaltet. Die Rahmenkomponente 16 ist als insgesamt in etwa L-förmige Backplane-Profilkomponente mit einem flächigen Steckerträgerabschnitt 17 und einem hierzu senkrecht angeordneten, ebenfalls flächigen Schienenträgerabschnitt 18 ausgeführt. Der Steckerträgerabschnitt 17 trägt eine Leiterplattenkonfiguration 19 mit den Multipol-Steckverbindern 12 bis 15. Die Modul-Tragschieneneinheit 8 ist als zur Rahmenkomponente 16 separate Einheit ausgeführt.

Die Modul-Tragschieneneinheit 8 insgesamt ist aus Kunststoff ausgeführt.

Die Rahmenkomponente 16, nämlich der Schienenträgerabschnitt 18, ist mit den Modul-Tragschienen 9 über Rahmenschienen 20 der Rahmenkomponente 16 verbunden, wobei in die Rahmenschienen 20 hierzu komplementäre Verbindungsschienen 21 der Modul-Tragschieneneinheit 8 eingreifen. Die Rahmenschienen 20 verlaufen senkrecht zu den Modul-Tragschienen 9. Die Rahmenschienen 20 verlaufen also parallel zur Hauptebene des Steckerträgerabschnitts 17, wohingegen die Modul-Tragschienen 9 senkrecht zur Hauptebene des Steckerträgerabschnitts 17 verlaufen.

Jeder der Modul-Aufnahmeplätze 6, 7 hat eine Rastaufnahme 22 zur rastenden Aufnahme des jeweiligen Elektronik-Gehäusemoduls 2, 3. Diese Rastaufnahme weist einen Betätigungsgriff 23 auf.

Die Trag- und Andockeinrichtung 1 wird folgendermaßen eingesetzt: Bei der Konfiguration der zugehörigen Maschine wird die Rahmenkomponente 16 über entsprechende Befestigungskomponente mit einem Maschinenrahmen verbunden. Die Montage der Rahmenkomponente 16 kann an einem Maschinengestell oder auch an einer Tischplatte-Unterseite erfolgen.

Bei der Konfiguration der Maschine wird entschieden, wie viele Elektronik-Gehäusemodule zur Steuerungs-Bestückung der Maschine erforderlich sind und abhängig hiervon wird die Anzahl der notwendigen Modul-Aufnahmeplätze 6, 7 vorgegeben, wobei hierbei berücksichtigt werden kann, dass noch zukünftig bestückbare Modul-Aufnahmeplätze vorgehalten werden.

Gegebenenfalls werden gleich mehrere nach Art der Figur 7 kaskadiert angeordnete Trag- und Andockeinrichtungen 1 verbaut. Bei der weiteren Konfigurierung der Maschine werden dann die entsprechend bestückten Elektronik-Gehäusemodule 2, 3 in die Modul-Aufnahmeplätze 6, 7 eingeschoben, wobei die Modul-Tragschiene 9 des jeweiligen Modul-Aufnahmeplatzes 6, 7, die Schienenaufnahmen 11 des jeweiligen Elektronik-Gehäusemoduls 2, 3 untergreifen. Das Einschieben des jeweiligen Elektronik-Gehäusemoduls 2, 3 erfolgt, bis eine Vorderkante 24 im oberen Bereich einer Frontseite 25 des jeweiligen Gehäusemoduls 2, 3 von der Rastaufnahme 22 hintergriffen wird. In dieser Position erfolgt aufgrund der entsprechenden Dimensionierung der Modul-Aufnahmeplätze 6, 7 relativ zur Länge der Elektronik-Gehäusemodule 2, 3 eine sichere Steckverbindung der Multipol-Steckverbinder 12, 13 des jeweiligen Modul-Aufnahmeplatzes 6, 7 mit hierzu komplementären Multipol-Steckverbindern der Elektronik-Gehäusemodule 2, 3.

Zum Ausbau beziehungsweise Wechsel eines in der Trag- und Andockeinrichtung 1 aufgenommenen Elektronik-Gehäusemoduls 2 wird der Betätigungsgriff 23 soweit nach oben ausgelenkt, bis die Rastaufnahme 22 außer Eingriff mit der Vorderkante 24 des Elektronik-Gehäusemoduls 2, 3 kommt, sodass das Elektronik-Gehäusemodul 2, 3 aus dem Modul-Aufnahmeplatz 6, 7 herausgezogen werden kann, wobei das Elektronik-Gehäusemodul 2, 3 vom zugehörigen Multipol-Steckverbinder 12, 13 abgesteckt wird.

Es können Elektronik-Gehäusemodule 2 mit unterschiedlichen Höhenabmessungen verbaut werden, da die Trag- und Andockeinrichtung 1 gegenüberliegend zum Schienentiägerabschnitt 18 räumlich nicht begrenzt ist.

Grundsätzlich können auch Elektronik-Gehäusemodule 2 verbaut werden, die mehrere Modul-Aufnahmeplätze 6, 7 belegen.

Zum Schutz von Multipol-Steckverbindern aktuell nicht bestückter Modul-Aufnahmeplätze 6, 7 hat die Trag- und Andockeinrichtung 1 Schutzabdeckungen 26. Figur 4 zeigt eine derartige Schutzabdeckung 26 für den Multipol-Steckverbinder 13 des Modul-Aufnahmeplatzes 7. Die Schutzabdeckung 26 ist vom hiermit gestützten Multipol-Steckverbinder 12, 13 lösbar. Entsprechende Schutzabdeckungen können auch für nicht genutzte Sammel-Multipol-Steckverbinder nach Art der Steckverbinder 14, 15 vorgesehen sein.

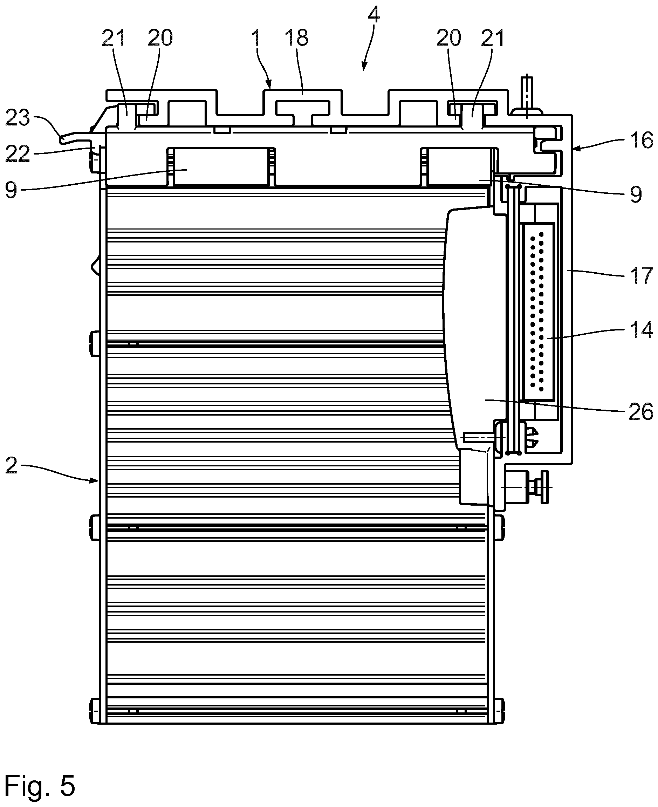

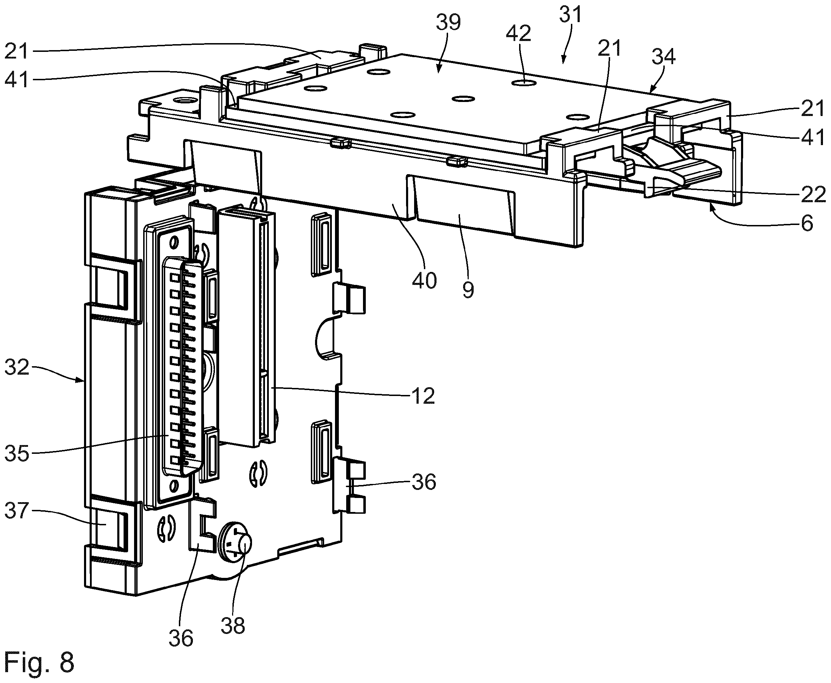

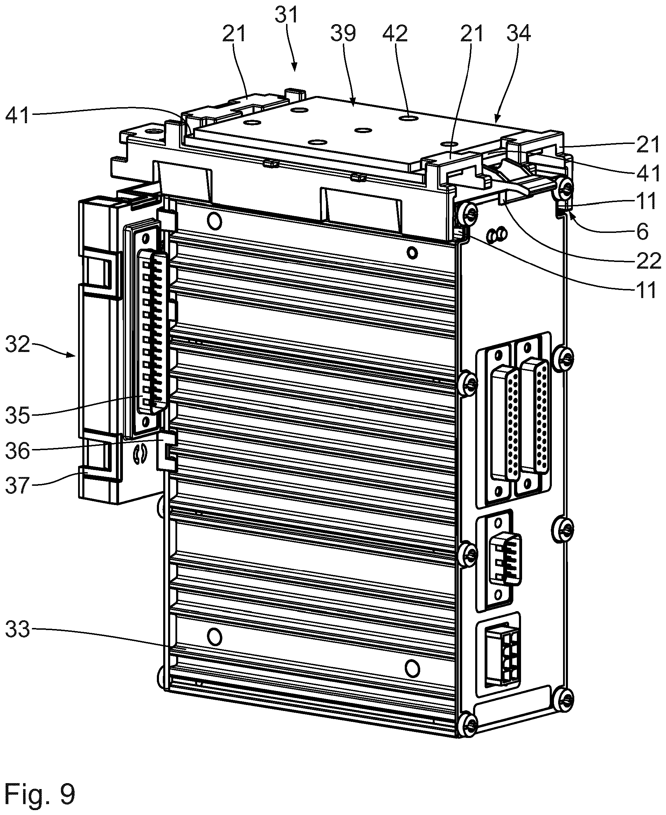

Anhand der Fig. 8 und 9 wird nachfolgend eine weitere Ausführung einer Trag- und Andockeinrichtung 31 erläutert. Komponenten, die denjenigen entsprechen, die vorstehend unter Bezugnahme auch die Fig. 1 bis 7 bereits beschrieben wurden, tragen die gleichen Bezugsziffern und werden nicht nochmals im Einzelnen diskutiert.

Die Trag- und Andockeinrichtung 31 hat zwei Hauptkomponenten, die voneinander getrennt ausgeführt sind, nämlich
- einen Moduladapter 32 mit genau einem Mulitpol-Steckverbinder 12 zur elektrischen Verbindung mit einem aufnehmbaren Elektronik-Gehäusemodul (vgl. hierzu die weitere Ausführung eines Elektronik-Gehäusemoduls 33, dargestellt in der Fig. 9) und
- eine Modul-Tragschieneneinheit 34, die Modul-Tragschienen 9 zur Aufnahme der entsprechenden Schienenaufnahme 11 des Elektronik-Gehäusemoduls 34 aufweist.

Die Trag- und Andockeinrichtung 31 hat genau einen Modul-Aufnahmeplatz 6 mit einer Hängeaufnahme, gebildet durch die Modul-Tragschieneneinheit 34 und mit dem Mulitpol-Steckverbinder 12 des Moduladapters 32. Bei der Trag- und Andockeinrichtung 31 ist der Modul-Aufnahmeplatz 6 also über entsprechende Abschnitte einerseits des Moduladapters 32 und andererseits der separat hiervon mit dem Elektronik-Gehäusemodul 33 verbindbaren Modul-Tragschieneneinheit 34 gebildet.

Der Moduladapter 32 hat einen Sammel-Multipol-Steckverbinder 35 zur elektrischen Verbindung des Modul-Aufnahmeplatzes 6 der Trag- und Andockeinrichtung 31, insbesondere des Mulitpol-Steckverbinders 12 mit der externen Komponente entsprechend dem, was vorstehend im Zusammenhang mit der Trag- und Andockeinrichtung 1 bereits erläutert wurde.

Der Moduladapter 32 weist mehrere Rastaufnahmen 36 in Form von beispielsweise sechs Schnapphaken auf, die wie die Rastaufnahme 22 an der Modul-Tragschieneneinheit 34 zur rastendenden Verbindung der jeweiligen Hauptkomponente 32, 34 der Trag- und Andockeinrichtung 31 am Elektronik-Gehäusemodul 33 dienen.

Der Moduladapter 32 wird bei der Trag- und Andockeinrichtung 31 also auf das Elektronik-Gehäusemodul 33 aufgesteckt und verrastet mit diesem über die Rastaufnahmen 36.

Bei der Trag- und Andockeinrichtung 31 ist der Mulitpol-Steckverbinder 12 mit den Sammel-Multipol-Steckverbinder 35 über eine in einem Gehäuse des Moduladapters 33 untergebrachte Leiterkarte/Leiterplatte verbunden.

Das Gehäuse des Moduladapters 32 ist zweiteilig, wobei die Gehäuseteile wiederum über Rastaufnahmen 37 miteinander verbunden sind.

Der Moduladapter 32 hat eine optionale Verbindungskomponente 38 zur Schaffung insbesondere einer elektrischen Kontaktierung mit einer optional vorhandenen zusätzlichen Rahmenkomponente entsprechend der Rahmenkomponente 16 der vorstehend beschriebenen Ausführung der Trag- und Andockeinrichtung 1. Zudem kann über die Verbindungskomponente 38, die als Schraubverbindung ausgeführt sein kann, eine mechanische Verbindung des Moduladapters 33 mit dieser Rahmenkomponente erfolgen.

Die Modul-Tragschieneneinheit 34 hat einen grundsätzlichen Aufbau, der demjenigen entspricht, der vorstehend im Zusammenhang mit der Modul-Tragschieneneinheit 8 der Ausführung nach den Fig. 1 bis 7 bereits erläutert wurde.

Anstelle des Schienenträgerabschnitts 18 ist bei der Modul-Tragschieneneinheit 34 eine Trägerplatte 39 vorgehen, welches mit einem Grundkörper 40 der Modul-Tragschieneneinheit 34 über die Verbindungsschienen-Komponenten 21 verbunden ist, die randseitige Verbindungsschienen 41 der Trägerplatte 39 hintergreifen. Über Verbindungsbolzen, beispielsweise Schrauben, die von unten her durch Montageöffnungen 42 der Trägerplatte 39 geführt sind, kann die Modul-Tragschieneneinheit 34 an einem nicht dargestellten Tragrahmen befestigt werden. Die Trägerplatte 39 kann als Halteblech, insbesondere als Blechpaket aus zwei miteinander verschweißten Blechen, ausgeführt sein.

Zur Montage der Modul-Tragschieneneinheit 34 wird die Trägerplatte 39 über die Verbindungsschienen-Anordnung 21, 41 auf den Grundkörper der Modul-Tragschieneneinheit 34 aufgeschoben und über die Trägerplatte 39 wird dann die Modul-Tragschieneneinheit 34 mit dem externen Tragrahmen verbunden, beispielsweise verschraubt. Anschließend kann das Elektronik-Gehäusemodul 33 in die Modul-Tragschieneneinheit 34 eingeschoben und mit der Rastaufnahme 22 fixiert werden. Entweder im Anschluss hieran oder bereits im Vorfeld kann der Moduladapter 32 der Trag- und Andockeinrichtung 31 mit dem Elektronik-Gehäusemodul 33 über die Rastaufnahmen 36 verbunden werden, wobei über die Multipol-Steckverbinder 12 eine Signalverbindung zwischen der Trag- und Andockeinrichtung 31 und dem Elektronik-Gehäusemodul 33 hergestellt wird. Die Trag- und Andockeinrichtung 33 kann dann mit der externen Komponente über den Sammel-Multipol-Steckverbinder 35 beispielsweise über ein entsprechendes Kabel verbunden werden.

Anders als bei der Trag- und Andockeinrichtung 1, wo die Sammel-Multipol-Steckverbinder 14, 15 seitlich am Steckerträgerabschnitt 17 angebracht sind, ist der Sammel-Multipol-Steckverbinder 35 bei der Trag-und Andockeinrichtung 31 zur gleichen Seite hin orientiert wie der Multipol-Steckverbinder 12.

## Patentansprüche

1. Trag- und Andockeinrichtung (1; 31) für Elektronik-Gehäusemodule (2, 3),
- mit mindestens einem Modul-Aufnahmeplatz (6, 7) zur hängenden Aufnahme von jeweils mindestens einem Elektronik-Gehäusemodul (2, 3; 33)
- wobei der Modul-Aufnahmeplatz (6, 7) aufweist:
-- eine Hängeaufnahme mit einer Modul-Tragschieneneinheit (8; 34) mit Modul-Tragschienen (9), die so ausgeführt sind, dass sie mit komplementär am jeweils aufnehmbaren Elektronik-Gehäusemodul (2, 3; 33) ausgeführten Schienenaufnahmen (11) zur tragenden Halterung zusammenwirken können,
-- einen Multipol-Steckverbinder (12, 13) zur elektrischen Verbindung mit dem jeweils aufnehmbaren Elektronik-Gehäusemodul (2, 3; 33),
- mit mindestens einem Sammel-Multipol-Steckverbinder (14, 15; 35) zur elektrischen Verbindung der Modul-Aufnahmeplätze (6, 7) mit einer externen Komponente,
- mit einer Rahmenkomponente (16), über die die Trag- und Andockeinrichtung (1) an einem externen Rahmenträger zur Halterung der Trag- und Andockeinrichtung (1) montiert werden kann, wobei die Modul-Tragschieneneinheit (8; 34) als zur Rahmenkomponente (16) separate Einheit ausgeführt ist,
- wobei die Rahmenkomponente (16) mit den Modul-Tragschienen (9) der Modul-Tragschieneneinheit (8) über Rahmenschienen (20) der Rahmenkomponente (16) verbunden ist, in die komplementäre Verbindungsschienen (21) der Modul-Tragschieneneinheit (8) eingreifen,
- wobei die Rahmenschienen (20) senkrecht zu den Modul-Tragschienen (9) verlaufen.

2. Trag- und Andockeinrichtung nach Anspruch 1, **dadurch gekennzeichnet, dass** der Sammel-Multipol-Steckverbinder (14, 15) eine Steckereinheit und eine hierzu komplementäre Buchseneinheit aufweist.

3. Trag- und Andockeinrichtung nach einem der Ansprüche 1 bis 2, **dadurch gekennzeichnet, dass** die Modul-Tragschieneneinheit (8; 34) aus Kunststoff ausgeführt ist.

4. Trag- und Andockeinrichtung nach einem der Ansprüche 1 bis 3, **dadurch gekennzeichnet, dass** der mindestens eine Modul-Aufnahmeplatz (6, 7) mindestens eine Rastaufnahme (22, 36) zur rastenden Aufnahme des jeweiligen Elektronik-Gehäusemoduls (2, 3; 33) aufweist.

5. Trag- und Andockeinrichtung nach einem der Ansprüche 1 bis 4, **gekennzeichnet durch** eine Schutzabdeckung (26) für einen nicht genutzten Multipol-Steckverbinder (12, 13, 14, 15; 35).

6. Elektronik-Baugruppe (4; 5)
- mit einer Trag- und Andockeinrichtung (1; 31) nach einem der Ansprüche 1 bis 5,
- mit mindestens einem Elektronik-Gehäusemodul (2; 2, 3; 33) mit kopfseitig angebrachten Schienenaufnahmen (11), die komplementär zu den Tragschienen (9) des jeweiligen Modul-Aufnahmeplatzes (6, 7) zur hängenden tragenden Halterung des Elektronik-Gehäusemoduls (2; 2, 3; 33) ausgeführt sind.

7. Nähmaschine mit einer Elektronik-Baugruppe (4; 5)
- mit einer Trag- und Andockeinrichtung (1; 31) für Elektronik-Gehäusemodule (2, 3),
-- mit mindestens einem Modul-Aufnahmeplatz (6, 7) zur hängenden Aufnahme von jeweils mindestens einem Elektronik-Gehäusemodul (2, 3; 33)
-- wobei der Modul-Aufnahmeplatz (6, 7) aufweist:
--- eine Hängeaufnahme mit einer Modul-Tragschieneneinheit (8; 34) mit Modul-Tragschienen (9), die so ausgeführt sind, dass sie mit komplementär am jeweils aufnehmbaren Elektronik-Gehäusemodul (2, 3; 33) ausgeführten Schienenaufnahmen (11) zur tragenden Halterung zusammenwirken können,
--- einen Multipol-Steckverbinder (12, 13) zur elektrischen Verbindung mit dem jeweils aufnehmbaren Elektronik-Gehäusemodul (2, 3; 33),
-- mit mindestens einem Sammel-Multipol-Steckverbinder (14, 15; 35) zur elektrischen Verbindung der Modul-Aufnahmeplätze (6, 7) mit einer externen Komponente,
- mit mindestens einem Elektronik-Gehäusemodul (2; 2, 3; 33) mit kopfseitig angebrachten Schienenaufnahmen (11), die komplementär zu den Tragschienen (9) des jeweiligen Modul-Aufnahmeplatzes (6, 7) zur hängenden tragenden Halterung des Elektronik-Gehäusemoduls (2; 2, 3; 33) ausgeführt sind.

## Claims

1. Support and docking device (1; 31) for electronics housing modules (2, 3),
- with at least one module receiving locations (6, 7) at least one electronics housing module (2, 3; 33) to be received in a suspended manner in each case
- wherein the module receiving location (6, 7) has:
-- a suspension receptacle with a module supporting rail unit (8; 34) with module supporting rails (9), which are designed such that they can cooperate with rail receptacles (11), which are designed in a complementary manner on the respective receivable electronics housing module (2, 3; 33), to be held in a supporting manner,
-- a multi-pin connector (12, 13) for the electrical connection to the respective receivable electronics housing module (2, 3; 33),
- with at least one collective multi-pin connector (14, 15; 35) for the electrical connection of the module receiving locations (6, 7) to an external component,
- with a frame component (16) via which the support and docking device (1) can be mounted on an external frame support for holding the support and docking device (1), wherein the module supporting rail unit (8; 34) is designed as a separate unit from the frame component (16),
- wherein the frame component (16) is connected to the module supporting rails (9) of the module supporting rail unit (8) via frame rails (20) of the frame component (16) in which complementary connecting rails (21) of the module supporting rail unit (8) engage,
- wherein the frame rails (20) are perpendicular to the module supporting rails (9).

2. Support and docking device according to claim 1, **characterized in that** the collective multi-pin connector (14, 15) comprises a plug unit and a socket unit complementary thereto.

3. Support and docking device according to one of claims 1 to 2, **characterized in that** the module supporting rail unit (8; 34) is made of plastic.

4. Supporting and docking device according to any one of claims 1 to 3, **characterized in that** the at least one module receiving location (6, 7) has at least one latching receptacle (22, 36) for receiving the respective electronics housing module (2, 3; 33) in a latching manner.

5. Support and docking device according to any one of claims 1 to 4, **characterized by** a protective cover (26) for an unused multi-pin connector (12, 13, 14, 15; 35).

6. Electronics assembly (4; 5)
- with a support and docking device (1; 31) according to any one of claims 1 to 5,
- with at least one electronics housing module (2; 2, 3; 33) with rail receptacles (11) mounted on the head side, which are designed to be complementary to the supporting rails (9) of the respective module receiving location (6, 7) for the electronics housing module (2; 2, 3; 33) to be held in a suspended supporting manner.

7. Sewing machine with an electronic assembly (4; 5)
- with a support and docking device (1; 31) for electronics housing modules (2, 3),
-- with at least one module receiving location (6, 7) for at least one electronics housing module (2, 3; 33) to be received in a suspended manner of in each case
-- wherein the module receiving location (6, 7) has:
--- a suspension receptacle with a module supporting rail unit (8; 34) with module supporting rails (9), which are designed such that they can cooperate with rail receptacles (11), which are designed in a complementary manner on the respective receivable electronics housing module (2, 3; 33), to be held in a supporting manner,
--- a multi-pin connector (12, 13) for the electrical connection to the respective receivable electronics housing module (2, 3; 33),
-- with at least one collective multipole connector (14, 15; 35) for the electrical connection of the module receiving locations (6, 7) to an external component,
- with at least one electronics housing module (2; 2, 3; 33) with rail receptacles (11) mounted on the head side, which are designed to be complementary to the supporting rails (9) of the respective module receiving locations (6, 7) for the electronics housing module (2; 2, 3; 33) to be held in a suspended supporting manner.

## Revendications

1. Dispositif de support et d'arrimage (1 ; 31) pour les modules de boîtier électronique (2, 3),
- avec au moins un emplacement de réception de module (6, 7) pour la réception suspendue d'au moins un module de boîtier électronique (2, 3 ; 33) à la fois
- dans lequel l'emplacement de réception du module (6, 7) présente
-- un logement suspendu avec une unité de rails porteurs de modules (8 ; 34) avec des rails porteurs de modules (9) qui sont réalisés de telle sorte qu'ils peuvent coopérer avec des logements de rails (11) réalisés de manière complémentaire sur le module de boîtier électronique (2, 3 ; 33) pouvant être respectivement logé pour former un support porteur,
-- un connecteur à fiches multipolaire (12, 13) pour la liaison électrique avec le module de boîtier électronique (2, 3 ; 33) pouvant être respectivement logé,
- avec au moins un connecteur à fiches multipolaire collectif (14, 15 ; 35) pour la liaison électrique des emplacements de réception de modules (6, 7) avec un composant externe,
- avec un composant de cadre (16), par l'intermédiaire duquel le dispositif de support et d'arrimage (1) peut être monté sur un support de cadre externe pour la fixation du dispositif de support et d'arrimage (1), l'unité de rails porteurs de modules (8 ; 34) étant réalisée sous forme d'unité séparée du composant de cadre (16),
- dans lequel le composant de cadre (16) est relié aux rails porteurs de module (9) de l'unité de rails porteurs de modules (8) par des rails de cadre (20) du composant de cadre (16) dans lesquels s'engagent des rails de liaison complémentaires (21) de l'unité de rails porteurs de modules (8),
- dans lequel les rails de cadre (20) s'étendent perpendiculairement aux rails porteurs de modules (9).

2. Dispositif de support et d'arrimage selon la revendication 1, **caractérisé en ce que** le connecteur à fiches multipolaire collectif (14, 15) présente une unité de fiche et une unité de douille complémentaire à celle-ci.

3. Dispositif de support et d'arrimage selon l'une quelconque des revendications 1 à 2, **caractérisé en ce que** l'unité de rails porteurs de modules (8 ; 34) est réalisée en matière plastique.

4. Dispositif de support et d'arrimage selon l'une quelconque des revendications 1 à 3, **caractérisé en ce que** l'au moins un emplacement de réception de module (6, 7) présente au moins un logement d'encliquetage (22, 36) pour la réception par encliquetage du module de boîtier électronique (2, 3 ; 33) respectif.

5. Dispositif de support et d'arrimage selon l'une quelconque des revendications 1 à 4, **caractérisé par** un couvercle de protection (26) pour un connecteur à fiches multipolaire (12, 13, 14, 15 ; 35) non utilisé.

6. Module électronique (4 ; 5)
- avec un dispositif de support et d'arrimage (1 ; 31) selon l'une quelconque des revendications 1 à 5,
- avec au moins un module de boîtier électronique (2 ; 2, 3 ; 33) avec des logements de rails (11) placés côté tête, qui sont réalisés de manière complémentaire aux rails porteurs (9) de l'emplacement de réception de module (6, 7) respectif pour la fixation porteuse suspendue du module de boîtier électronique (2 ; 2, 3 ; 33).

7. Machine à coudre avec un module électronique (4 ; 5)
- avec un dispositif de support et d'arrimage (1 ; 31) pour des modules de boîtier électronique (2, 3),
-- avec au moins un emplacement de réception de module (6, 7) pour la réception suspendue d'au moins un module de boîtier électronique (2, 3 ; 33) à la fois
-- dans lequel l'emplacement de réception du module (6, 7) présente
--- un logement suspendu avec une unité de rails porteurs de modules (8 ; 34) avec des rails porteurs de modules (9) qui sont réalisés de telle sorte qu'ils peuvent coopérer avec des logements de rails (11) réalisés de manière complémentaire sur le module de boîtier électronique (2, 3 ; 33) pouvant être respectivement logé pour former un support porteur,
--- un connecteur à fiches multipolaire (12, 13) pour la liaison électrique avec le module de boîtier électronique (2, 3 ; 33) pouvant être respectivement logé,
-- avec au moins un connecteur à fiches multipolaire collectif (14, 15 ; 35) pour la liaison électrique des emplacements de réception de modules (6, 7) avec un composant externe,
- avec au moins un module de boîtier électronique (2 ; 2, 3 ; 33) avec des logements de rails (11) placés côté tête, qui sont réalisés de manière complémentaire aux rails porteurs (9) de l'emplacement de réception de module (6, 7) respectif pour la fixation porteuse suspendue du module de boîtier électronique (2 ; 2, 3 ; 33).
